# EUROPÄISCHE PATENTSCHRIFT

(11) **EP 2 574 939 B1**
(45) Veröffentlichungstag und Bekanntmachung des Hinweises auf die Patenterteilung: **25.10.2023**
(21) Anmeldenummer: 12184887.3
(22) Anmeldetag: 18.09.2012
(51) Int. Cl.: G01R 31/08

(54) **Isolationsfehlersuchgerät und Vorrichtung zur Isolationsfehlerlokalisierung in einem ungeerdeten Stromversorgungsnetz**
Isolation fault detection device and device for insulation fault localisation in an unearthed power supply network
Appareil de détection de défauts d'isolation et dispositif de localisation de défauts d'isolation dans un réseau d'alimentation de courant non mis à la terre

(30) Priorität: 29.09.2011 DE 102011083792
(43) Veröffentlichungstag der Anmeldung: 03.04.2013
(73) Patentinhaber: Bender GmbH & Co. KG, 35305 Grünberg (DE)
(72) Erfinder: Schäfer, Oliver, 35305 Grünberg (DE); Möll, Winfried, 35321 Laubach (DE); Dalitz, Friedhelm, 35305 Grünberg (DE)
(74) Vertreter: advotec.

(56) Entgegenhaltungen:
- CN-U- 201 955 425
- CN-Y- 2 228 236
- DE-A1- 19 925 349
- DE-A1-102005 025 541
- DE-U1-202011 004 767
- FR-A1- 2 863 115
- GB-A- 1 214 678
- US-A- 4 884 034
- US-A- 5 065 104
- US-B1- 7 529 069

## Beschreibung

Die Erfindung betrifft ein Isolationsfehlersuchgerät zur Isolationsfehlerlokalisierung in einem ungeerdeten Stromversorgungsnetz, mit genau einem Messkanal und mindestens einer Strommesseinrichtung sowie einer Auswerteeinrichtung.

Weiterhin betrifft die Erfindung eine Vorrichtung zur Isolationsfehlerlokalisierung in einem ungeerdeten Stromversorgungsnetz, mit einem Prüfgerät zur Erzeugung eines Prüfstroms und mit einem erfindungsgemäßen Isolationsfehlersuchgerät.

Um eine hohe Verfügbarkeit und Betriebssicherheit der elektrischen Stromversorgung sicherzustellen sowie die Personensicherheit im Bereich elektrischer Anlagen zu gewährleisten, ist es notwendig, Isolationsfehler in Leitungsnetzen zu erkennen, bevor die Anlage automatisch abschaltet oder bei Berührung eines aktiven Leiters gefährliche Körperströme fließen können. Zur Stromversorgung wichtiger Anlagen und Verbraucher, z.B. in medizinisch genutzten Räumen, werden daher ungeerdete Netze (IT-Systeme) mit Isolationsüberwachung eingesetzt. Wegen des im Idealfall unendlich großen Impedanzwertes zwischen Leiter und Erde, fließt bei einem Isolationsfehler kein Kurzschlussstrom, sodass die Spannungsversorgung bei diesem einpoligen Erdschluss ("erster Fehler") noch sichergestellt ist. Auch der Personenschutz ist gewährleistet, da bei Berühren eines aktiven Leiters kein geschlossener Stromkreis mit einem über die (geerdete) Person fließenden Strom entstehen kann.

Wird das Stromversorgungsnetz bei Vorliegen eines "ersten Fehlers" weiter betrieben, dann ist auf Grund dieses Fehlers aus dem bisher ungeerdeten Netz ein geerdetes System entstanden, sodass ein weiterer Fehler zur Abschaltung der Anlage oder die Berührung eines aktiven Leiters zu einem gefährlichen Körperstrom führen kann. Eine schnelle Lokalisierung und Beseitigung von Isolationsfehlern ist daher erforderlich.

Isolationsüberwachungsgeräte überwachen das Isolationsniveau des IT-Netzes und erzeugen eine Warnmeldung, sobald der Isolationswiderstand einen vorbestimmten Ansprechwert unterschreitet. Mit dieser Meldung startet in fest installierten Systemen automatisch eine Isolationsfehlersuche mit Hilfe einer Isolationsfehlersucheinrichtung. Diese besteht aus einem Isolationsüberwachungsgerät (mit Prüfstromgenerator) oder einem besonderen Prüfgerät sowie einem Isolationsfehler-Auswertegerät in Verbindung mit einem oder mehreren Messstromwandlern. Das Isolationsüberwachungsgerät oder das Prüfgerät überlagert dem Netz eine Messspannung, die in einer fehlerhaften Leitung zu einem dem Isolationsfehler proportionalen Prüfstrom führt. Dieses Prüfstromsignal wird von allen Messstromwandlern, die in einem fehlerbehafteten Leitungsabgang liegen, erfasst und durch ein Isolationsfehler-Auswertegerät ausgewertet und angezeigt. Durch die Zuordnung Messstromwandler/Stromkreis bzw. Leitungsabgang kann der Fehlerort lokalisiert werden.

Als nachteilig erweist sich, dass im Fall eines schadhaften Verbrauchers mit Fehlersucheinrichtungen, die zumeist in Schaltschränken eingebaut sind, zwar der fehlerhafte Leitungsabgang ermittelt werden kann, ein direkter Bezug zu der jeweiligen Steckdose, an die der fehlerhafte Verbraucher angeschlossen ist, aber nicht gegeben ist. Dies gilt für alle elektrischen Anlagen, die als IT-Netze, nicht nur in Gebäuden, sondern auch auf Schiffen oder in Fahrzeugen installiert sind. Die eingesetzten Fehlersucheinrichtungen erkennen lediglich den fehlerhaften Stromabgang, nicht aber den entsprechenden Verbraucher, da diese weit verzweigt an Unterverteilanlagen angeschlossen sind. Zur genauen Lokalisierung wird in Ergänzung zu dem fest installierten Fehlersuchsystem zusätzlich eine manuelle Isolationsfehlersuche mit portablen Fehlersuchsystemen durchgeführt. Die nachträgliche Lokalisierung erlaubt dann die Lokalisierung in untergeordneten Leitungsabgängen bis hin zu einzelnen Verbraucheranschlüssen. Alternativ kann durch Trennen einzelner Verbraucher vom Netz und unter gleichzeitiger Beobachtung des fest installierten Fehlersuchsystems der fehlerhafte Verbraucher lokalisiert werden. Insgesamt betrachtet gestaltet sich die Isolationsfehlersuche sehr aufwendig und kann nur von einer Elektrofachkraft durchgeführt werden.

Aus der Entgegenhaltung US 7,529,069 B1 ist ein System zur Erdschlusserkennung und Lokalisierung in einem ungeerdeten Stromversorgungsnetz bekannt. Das System besteht aus einem Hauptgerät und einer mit dem Hauptgerät kommunizierenden, vorzugsweise portablen Lokalisierungseinheit mit einem daran angeschlossenen Messstromwandler.

In der FR 2 863 115 ist ein Fehlerstromschutzschalter offenbart, welcher sich durch einen Prüfkreis zur Fehlerstromfunktionsprüfung auszeichnet, wobei der Prüfkreis nur einen geringen Bauraum beansprucht. Die Bauteile dieses Fehlerstromschutzschalters sind in ein aus Isolierstoff bestehendes Gehäuse eingekapselt.

Die GB 1 214 678 zeigt eine Fehlerstromüberwachungseinrichtung, deren Bauelemente in eine Steckdose integrierbar sind und die einen Summenstromwandler sowie ein Schaltelement umfasst.

Die US 4,884,034 zeigt eine vorzugsweise portable Vorrichtung zur Erdschlussfehlererkennung und -detektion, welche aus einem gepulsten Erdungsschaltkreis und einer Sensoreinheit besteht. An die Sensoreinheit ist eine Messzange anschließbar.

Die vorgenannten Vorrichtungen weisen den Nachteil auf, dass sie entweder mehrteilig sind oder als Fehlerstromschutzeinrichtungen für ungeerdete Stromversorgungssysteme als Isolationsfehlersuchgerät zur Isolationsfehlerlokalisierung ungeeignet sind.

Die DE 199 25 349 beschreibt eine Steckdosenleiste mit einer Netzzuleitung und mehreren in einem gemeinsamen Gehäuse angeordneten Steckdosen und mit einer in dem Gehäuse vorgesehene Überwachungseinrichtung, die eine Spannungs- oder Stromüberwachungseinheit sowie eine Ausgabeanschlussvorrichtungseinheit enthält.

Der vorliegenden Erfindung liegt somit die Aufgabe zu Grunde, den Prozess der Isolationsfehlersuche zur Lokalisierung eines fehlerhaften Verbrauchers effizienter zu gestalten und zu vereinfachen.

Diese Aufgabe wird mit dem Gegenstand des Anspruchs 1 gelöst.

Das Isolationsfehlersuchgerät weist genau einen Messkanal auf und besteht erfindungsgemäß aus mindestens einer Strommesseinrichtung und einer Auswerteeinrichtung, die in einer baulichen Einheit integriert sind. In Form eines Anbauteiles oder eines Adapterteils kann diese bauliche Einheit direkt an der Verbraucherzuleitung oder an der Unterverteilung installiert sein. Das über einen möglichen Isolationsfehler fließende Prüfstromsignal wird von der Strommesseinrichtung erfasst und sofort an gleicher Stelle von der Auswerteeinrichtung als Fehler signalisiert. Damit ist die Möglichkeit gegeben, auftretende Isolationsfehler gezielt dem verursachenden Verbraucher direkt zuordnen zu können. Ein Isolationsfehler kann auch von nicht fachkundigem Personal bemerkt werden und eine nachfolgende meist aufwändige manuelle Lokalisierung des Isolationsfehlers mit portablen Fehlersuchsystemen kann entfallen.

Die integrierte bauliche Einheit aus Strommesseinrichtung und Auswerteeinrichtung kann ein Adapterteil sein, welches als Zwischenstecker zum Aufstecken auf eine schutzkontakt-kompatible Steckverbindung ausgebildet ist oder ein Anbauteil sein, welches als Steckdose mit einer schutzkontakt-kompatiblen Steckverbindung ausgebildet ist, oder das mit elektrischen Kontakten zum direkten Anschluss von elektrischen Zuleitungen ausgebildet ist.

Bei einer Ausbildung als Adapterteil ist eine nachträgliche Installation problemlos möglich, da das Adapterteil in Form eines Zwischensteckers lediglich an der Schutzkontaktsteckdose in die Verbraucherzuleitung eingefügt werden muss. Eine Elektrofachkraft ist für diese Maßnahme nicht erforderlich.

Auch kann das integrierte Anbauteil selbst als Schutzkontakt-Steckdose ausgebildet sein. In diesem Fall dient das Anbauteil ohne weiteren Verdrahtungsaufwand als handelsübliche Schutzkontakt-Steckdose und erweitert deren Funktion um die Möglichkeit der Isolationsfehlersuche. Weiterhin ist eine Ausbildung des Anbauteils mit elektrischen Kontakten zum direkten Anschluss von elektrischen Zuleitungen von Vorteil. Ohne Auftrennen der Zuleitung kann das Anbauteil in dieser Ausführung an der zu prüfenden Anschlussleitung angebracht werden, wobei die Strommesseinrichtungen als - vorzugsweise teilbare - Messstromwandler ausgeführt sind und die Kontaktierung der Leiter durch Kontaktdorne erfolgen kann. Auch diese Ausführungsform eignet sich ohne umfangreiche Installationsarbeiten für eine nachträgliche Montage.

Mit Ausnahme der Ausführung als Anbauteil mit direkter Kontaktierung der elektrischen Zuleitungen ist die Strommesseinrichtung zweckmäßigerweise als Shunt-Widerstand zur Messung eines Laststroms ausgebildet. Dies erlaubt zusätzlich - neben der Erfassung des Prüfstroms durch weitere Strommesseinrichtungen - die Messung des Laststroms nach Betrag und Winkel und dient der Feststellung einer Überlast auf der überwachten Leitung.

Die Strommesseinrichtungen sind als Messstromwandler ausgebildet. Neben der vorrangigen Erfassung des Prüfstroms ermöglicht eine Umschaltung der Betriebsart auch die Messung eines Differenzstroms oder eines Laststroms. Da bei einem ohmschen Isolationsfehler in ungeerdeten Systemen zumeist auch ein Differenzstrom über die Ableitkapazitäten des Netzes fließt, vermittelt dessen Erkennung eine höhere Zuverlässigkeit bei der Isolationsfehlersuche. Zudem kann das Gerät in dem Differenzstrom- und dem Laststrommodus auch in geerdeten Stromversorgungssystemen eingesetzt werden.

Mit Vorteil weist das Gerät eine Netzankopplungsschaltung zur Netzspannungsmessung und zur Erdspannungsmessung auf. Die Netzspannungsmessung mit Betrag und Winkel bietet die Möglichkeit, bei Unter- oder Überspannung in der Zuleitung eine Warnmeldung auszugeben. Weiterhin kann mit Hilfe der Netzspannungsmessung und einer Erdspannungsmessung nach dem Unsymmetrieverfahren (U₁₂ = U_{1E}+U_{2E}, wobei U₁₂ die Spannung zwischen den Leitern und U_{1E} bzw. U_{2E} jeweils die Spannung gegen Erde ist) ein fehlerhafter Verbraucher beim Einstecken erkannt werden (Erdschlussschnellerkennung).

Durch die phasenrichtigen Messungen des Laststroms und der Netzspannung können die Wirkleistung und die Scheinleistung bzw. der Leistungsfaktor eines angeschlossenen Verbrauchers ermittelt werden. Weiterhin wird die Aufgabe dadurch gelöst, dass eine Vorrichtung zur Isolationsfehlerlokalisierung in einem ungeerdeten Stromversorgungsnetz mit einem Prüfgerät zur Erzeugung eines Prüfstroms ein erfindungsgemäßes Isolationsfehlersuchgerät nach einem der Ansprüche 1 bis 12 aufweist. Diese erfindungsgemäße Vorrichtung stellt somit eine vollständige Isolationsfehlersucheinrichtung dar, welche die Aktivierung eines Prüfstromsignals durch das Prüfgerät und die Erfassung und Auswertung des Prüfstromsignals durch das erfindungsgemäße Isolationsfehlersuchgerät umfasst.

In vorteilhafter Weise weist die Vorrichtung ein Signalisierungsgerät zur Anzeige der Messwerte sowie zur optischen und/oder akustischen Darstellung von Warn- und Statusmeldungen auf. Ein oder mehrere derartige Signalisierungsgeräte ermöglichen die Anzeige bzw. die Darstellung der von einem oder mehreren Isolationsfehlersuchgerät(en) erfassten und an das Signalisierungsgerät übertragenen Werte. Diese Werte können beispielsweise der Laststrom, der Differenzstrom, der Prüfstrom, die Netzspannung U₁₂, die Wirkleistung, die Scheinleistung oder die entnommene Energie sein kann.

Zur Auswertung der von separaten Messstromwandlern aufgenommenen Ströme weist die Vorrichtung ein zentrales Auswertegerät zur Verarbeitung der Daten mehrerer Messkanäle auf. Das Auswertegerät umfasst eine dem Signalisierungsgerät entsprechende Signalisierungseinheit zur Anzeige der Messwerte sowie zur optischen und/oder akustischen Darstellung von Warn- und Statusmeldungen. Alternativ oder zusätzlich können die über die Strommesseinrichtung des erfindungsgemäßen Isolationsfehlersuchgerätes erfassten Größen auch zentral in dem Auswertegerät verarbeitet werden.

Zwischen dem erfindungsgemäßen Isolationsfehlersuchgerät und dem Signalisierungsgerät und/oder zwischen dem erfindungsgemäßen Isolationsfehlersuchgerät und dem Auswertegerät ist eine Datenübertragungsstrecke eingerichtet. Diese Datenübertragung erlaubt die Auswertung und Darstellung der mit dem Isolationsfehlersuchgerät dezentral erfassten Größen an zentraler Stelle mit dem vorbeschriebenen Auswerte- bzw. Signalisierungsgerät. Dabei kann die Datenübertragungsstrecke leitungsgebunden oder drahtlos mit Sende- und Empfangseinrichtungen ausgebildet sein. Als leitungsgebundene Übertragungsverfahren kommen dem Leitungsnetz überlagerte modulierte Trägersignale wie z. B. Powerline Communication oder eigene für die Datenübertragung vorgesehene Leitungen wie z.B. Ethernet in Frage. Eine drahtlose Datenübertragung kann beispielsweise über Funksignale z.B. nach einem (Mobil-)Funk-Standard oder über Infrarot-Signale erfolgen. Dazu weisen das Isolationsfehlersuchgerät, das Auswertegerät sowie das Signalisierungsgerät jeweils eine dem Übertragungsverfahren entsprechende Sende- und Empfangseinrichtung auf.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern.

Es zeigen:
- **Fig. 1:**: ein funktionales Blockschaltbild des erfindungsgemäßen Isolationsfehlersuchgerätes;
- **Fig. 2:**: einen Steckdoseneinsatz einer Ausführungsform als Steckdose mit einer schutzkontakt-kompatiblen Steckverbindung.

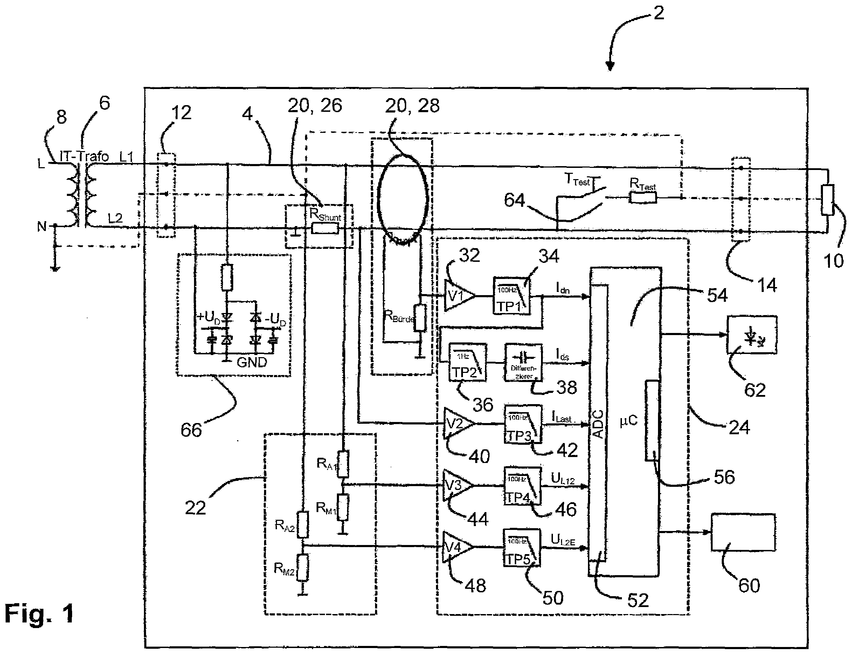

**Fig. 1** zeigt in einem funktionalen Blockschaltbild den prinzipiellen elektrischen Aufbau des erfindungsgemäßen Isolationsfehlersuchgerätes 2 zur Isolationfehlerlokalisierung in einem ungeerdeten Stromversorgungsnetz 4. Das ungeerdete Stromversorgungsnetz 4 ist eine aus den Leitern L₁ und L₂ gebildete Verbraucherzuleitung 4, die über einen Transformator 6 aus dem geerdeten Netz 8 gespeist wird und einen Verbraucher 10 versorgt. Die Verbraucherzuleitung 4 kann je nach Anwendungsfall ein Kabelabschnitt 4 einer festverlegten Installation eines IT-Netzes oder ein beliebiger freier Kabelabschnitt 4 sein. Im Fall einer Ausführung des Isolationsfehlersuchgerätes als Adapterteil ist das Isolationsfehlersuchgerät 2 zwischen einer Steckverbindung 12 des Kabelabschnitts 4 an eine Schutzkontaktsteckdose 12 und einer Steckverbindung 14 des Verbrauchers 10 an dem Kabelabschnitt 4 angeordnet.

Das Isolationsfehlersuchgerät 2 umfasst eine oder mehrere Strommesseinrichtungen 20, eine Netzankopplungsschaltung 22 und eine Auswerteeinrichtung 24. Die Strommesseinrichtungen 20 sind als Shunt-Widerstand 26 zur Messung eines Laststroms sowie als Messstromwandler 28 zur Erfassung eines Prüfstroms oder eines Differenzstroms ausgebildet.

Die Netzankopplungsschaltung 22 weist zur Netzspannungsmessung einen mit einem aktiven Leiter L₁ verbundenen ersten Ankopplungszweig mit einem Ankoppelwiderstand R_{A1} und einem Messwiderstand R_{M1} sowie zur Erdspannungsmessung einen mit Erdpotential verbundenen zweiten Ankopplungszweig mit einem Ankoppelwiderstand R_{A2} und einem Messwiderstand R_{M2} auf.

Zur Differenzstrommessung, zur Prüfstrommessung, zur Laststrommessung sowie zur Netzspannungsmessung und zur Erdspannungsmessung weist die Auswerteeinrichtung 24 jeweils einen Signalweg mit einer Verstärkerschaltung und einer nachfolgenden Filterschaltung auf. Dabei wird bei der Differenzstrommessung das erfasste Messsignal über eine eingangsseitig mit der Strommesseinrichtung 20, 28 verbundene erste Verstärkerschaltung 32 und eine nachfolgende erste Filterschaltung 34 geführt.

Zur Prüfstrommessung weist die Auswerteeinrichtung eine eingangsseitig mit dem Ausgang der ersten Filterschaltung 34 verbundene zweite Filterschaltung 36 und eine nachfolgende Differenziererschaltung 38 auf; zur Laststrommessung besitzt die Auswerteeinrichtung eine eingangsseitig mit dem Shunt-Widerstand 26 verbundene zweite Verstärkerschaltung 40 und eine nachfolgende dritte Filterschaltung 42.

Die Netzspannungsmessung erfolgt über eine eingangsseitig mit dem ersten Ankopplungszweig zwischen dem Ankoppelwiderstand R_{A1} und dem Messwiderstand R_{M1} verbundene dritte Verstärkerschaltung 44 und eine nachfolgende vierte Filterschaltung 46.

Zur Erdspannungsmessung ist eine eingangsseitig mit dem zweiten Ankopplungszweig zwischen dem Ankoppelwiderstand R_{A2} und dem Messwiderstand R_{M2} verbundene vierte Verstärkerschaltung 48 und eine nachfolgende fünfte Filterschaltung 50 vorgesehen.

Die Ausgänge der ersten Filterschaltung 34, der dritten 42, der vierten 46 und der fünften Filterschaltung 50 sowie der Differenziererschaltung 38 werden jeweils über einen AD-Umsetzer 52 einem Mikroprozessor 54 mit einer Speichereinheit 56 zugeführt.

Alternativ zu den in Fig. 1 dargestellten analogen Filterschaltungen 34, 36, 42, 46 und 50 kann die Signalfilterung auch in dem Mikroprozessor 54 auf digitaler Ebene mit Algorithmen der digitalen Signalverarbeitung durchgeführt werden.

Das Isolationsfehlersuchgerät 2 ist zur Übertragung von Messwerten und von Warn- und Statussignalen mit einer Datenschnittstelle 60 ausgestattet, die eine Sende- und Empfangseinrichtung zur leitungsgebunden oder zur drahtlosen Datenübertragung aufweist. Eine LED-Meldeanzeige 62 signalisiert den Betriebszustand des Gerätes 2 und warnt bei auftretenden Isolationsfehlern.

Des Weiteren besitzt das erfindungsgemäße Isolationsfehlersuchgerät 2 eine Prüfeinrichtung 64 zum Testen der Differenzstromauslösung sowie Netzteil 66 zur eigenen Energieversorgung aus dem Stromversorgungsnetz.

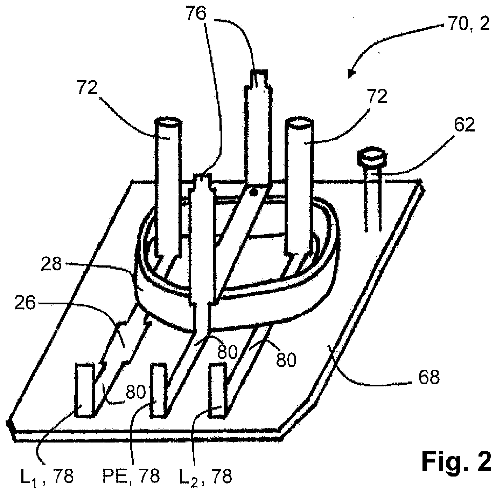

Fig. 2 beruht auf einer Ausführungsform des erfindungsgemäßen Isolationsfehlersuchgerätes 2 als Steckdose und zeigt eine Leiterplatte 68 als Steckdoseneinsatz 70 mit einer schutzkontakt-kompatiblen Steckverbindung. Die aktiven Leiter L₁ und L₂ sind als Steckkontakte 72 ausgebildet und werden von dem Messstromwandler 28 umschlossen, während der Erdleiter als Schutzkontakt 76 funktionsgemäß um den Messstromwandler 28 herumgeführt ist. Die fest installierten Stromleitungen werden über die Leiteranschlüsse 78 mit der Leiterplatte 68 verbunden und über Leiterbahnen 80 zu den Kontakten 72, 76 geführt.

Auf der Leiterplatte 68 ist der Shunt-Widerstand 26 in eine Leiterbahn 80 des Leiters L₁ eingefügt. Zur Signalisierung eines Alarms ist eine LED-Meldeanzeige 62 als Signalisierungseinrichtung 62 mit der Leiterplatte 68 elektrisch verbunden.

## Patentansprüche

1. Isolationsfehlersuchgerät (2) zur Isolationsfehlerlokalisierung in einem ungeerdeten Stromversorgungsnetz (4) mit jeweils aktiven Leitern (L1, L2), mit genau einem Messkanal und mindestens einer Strommesseinrichtung (20) sowie einer Auswerteeinrichtung (24), wobei die Strommesseinrichtung (20) und die Auswerteeinrichtung (24) als eine integrierte bauliche Einheit in Form eines Anbauteils (2) oder eines Adapterteils (2) ausgebildet sind, wobei das Anbauteil (2) als Steckdose (70) mit einer schutzkontakt-kompatiblen Steckverbindung ausgebildet ist oder das Adapterteil (2) als Zwischenstecker zum Aufstecken auf eine schutzkontakt-kompatible Steckverbindung ausgebildet ist und die Auswerteeinrichtung (24) einen Mikroprozessor (54) mit einer Speichereinheit (56) und einen oder mehrere AD-Umsetzer (52) aufweist, **dadurch gekennzeichnet,**
**dass** das Isolationsfehlersuchgerät (2) zur Differenzstrommessung sowohl in einem ungeerdeten als auch in einem geerdeten Stromversorgungssystem mit jeweils aktiven Leitern (L₁, L₂) ausgebildet ist, dass die Strommesseinrichtung (20) als Messstromwandler (28) ausgebildet ist,
**dass** der Messstromwandler (28) zur Erfassung eines Prüfstroms und zur Messung eines Differenzstroms ausgebildet ist,
und **dass** der Messstromwandler (28) die aktiven Leiter (L₁, L₂) umschließt

2. Gerät nach Anspruch 1,
**dadurch gekennzeichnet,**
**dass** das Anbauteil (2) mit elektrischen Kontakten zum direkten Anschluss von elektrischen Zuleitungen (4) ausgebildet ist.

3. Gerät nach Anspruch 1 oder 2, **dadurch gekennzeichnet, dass** eine zusätzliche Strommesseinrichtung (20) als Shunt-Widerstand (26) zur Messung eines Laststroms ausgebildet ist.

4. Gerät nach einem der Ansprüche 1 bis 3,
**gekennzeichnet durch**
eine Netzankopplungsschaltung (22) zur Netzspannungsmessung und zur Erdspannungsmessung.

5. Gerät nach einem der Ansprüche 1 bis 4,
**dadurch gekennzeichnet,**
**dass** die Auswerteeinrichtung (24) zur Differenzstrommessung, zur Prüfstrommessung, zur Laststrommessung, zur Netzspannungsmessung und zur Erdspannungsmessung jeweils einen Signalweg mit einer Verstärkerschaltung und einer nachfolgenden Filterschaltung aufweist.

6. Gerät nach Anspruch 5,
**dadurch gekennzeichnet,**
**dass** die Filterschaltungen (34, 36, 42, 46, 50) in digitaler Form als Software-Implementierungen ausgeführt sind.

7. Gerät nach einem der Ansprüche 1 bis 6,
**gekennzeichnet durch**
eine Datenschnittstelle (60) zur Übertragung von Messwerten und von Warn- und Statussignalen.

8. Gerät nach Anspruch 7,
**dadurch gekennzeichnet,**
**dass** die Datenschnittstelle (60) mit einer Sende- und Empfangseinrichtung (60) zur leitungsgebunden Datenübertragung ausgebildet ist.

9. Gerät nach Anspruch 7 oder 8,
**dadurch gekennzeichnet,**
**dass** die Datenschnittstelle (60) mit einer Sende- und Empfangseinrichtung (60) zur drahtlosen Datenübertragung ausgebildet ist.

10. Gerät nach einem der Ansprüche 1 bis 9,
**gekennzeichnet durch**
eine Signalisierungseinrichtung (62) zur Anzeige der Messwerte sowie zur optischen und/oder akustischen Darstellung von Warn- und Statusmeldungen.

11. Gerät nach einem der Ansprüche 1 bis 10,
**gekennzeichnet durch**
eine Prüfeinrichtung (64) zum Testen der Differenzstromauslösung.

12. Gerät nach einem der Ansprüche 1 bis 11,
**gekennzeichnet durch**
ein Netzteil (66) zur eigenen Energieversorgung aus dem Stromversorgungsnetz (4).

13. Vorrichtung zur Isolationsfehlerlokalisierung in einem ungeerdeten Stromversorgungsnetz (4), mit einem Prüfgerät zur Erzeugung eines Prüfstroms und mit einem Isolationsfehlersuchgerät (2) gemäß einem der Ansprüche 1 bis 12.

14. Vorrichtung nach Anspruch 13,
**gekennzeichnet durch**
ein Signalisierungsgerät zur Anzeige der Messwerte sowie zur optischen und/oder akustischen Darstellung von Warn- und Statusmeldungen.

15. Vorrichtung nach Anspruch 13 oder 14,
**gekennzeichnet durch**
ein zentrales Auswertegerät zur Verarbeitung der Daten mehrerer Messkanäle.

16. Vorrichtung nach Anspruch 14 oder 15,
**dadurch gekennzeichnet,**
**dass** zwischen dem erfindungsgemäßen Isolationsfehlersuchgerät (2) und dem Signalisierungsgerät und/oder zwischen dem erfindungsgemäßen Isolationsfehlersuchgerät (2) und dem Auswertegerät eine Datenübertragungsstrecke eingerichtet ist.

17. Vorrichtung nach Anspruch 16,
**dadurch gekennzeichnet,**
**dass** die Datenübertragungsstrecke leitungsgebunden mit Sende- und Empfangseinrichtungen (60) ausgebildet ist.

18. Vorrichtung nach Anspruch 16 oder 17,
**dadurch gekennzeichnet,**
**dass** die Datenübertragungsstrecke drahtlos mit Sende- und Empfangseinrichtungen (60) ausgebildet ist.

## Claims

1. An insulation fault location device (2) for insulation fault location in an ungrounded power supply network (4) having active conductors (L1, L2), the insulation fault location device (2) having precisely one measuring channel and at least one current measuring apparatus (20) and an evaluation apparatus (24), the current measuring apparatus (20) and the evaluation apparatus (24) being configured as an integrated structural unit in the form of an add-on piece (2) or an adapter piece (2), the add-on piece (2) being formed as a socket (70) having a plug connection compatible with grounding or the adapter piece (2) being formed as an intermediate plug for being plugged on a plug connection compatible with grounding and the evaluation apparatus (24) having a microprocessor (54) having a storage unit (56) and one or more analog-digital converters (52),
**characterized in that**
the insulation fault location device (2) is configured for measuring a residual current in both an ungrounded and a grounded power supply system each having active conductors (L1, L2), **in that** the current measuring device (20) is configured as a measuring current transformer (28), **in that** the measuring current transformer (28) is configured for registering a test current and for measuring a residual current, and **in that** the measuring current transformer (28) encloses the active conductors (L1, L2).

2. The device according to claim 1,
**characterized in that**
the add-on piece (2) is configured having electric contacts for directly connecting electric supply lines (4).

3. The device according to claim 1 or 2,
**characterized in that**
an additional current measuring device (20) is configured as a shunt-resistance (26) for measuring a load current.

4. The device according to any one of the claims 1 to 3, **characterized by**
a network coupling circuit (22) for measuring a network voltage and a ground voltage.

5. The device according to any one of the claims 1 to 4,
**characterized in that**
the evaluation apparatus (24) has a signal path having an amplifier circuit and a subsequent filter circuit for measuring each of the following: a residual current, a test current, a load current, a network voltage and a ground voltage.

6. The device according to claim 5,
**characterized in that**
the filter circuits (34, 36, 42, 46, 50) are designed as software implementations in digital form.

7. The device according to any one of the claims 1 to 6,
**characterized by**
a data interface (60) for transmitting measured values and warning and status signals.

8. The device according to claim 7,
**characterized in that**
the data interface (60) is designed having a transmitter and receiver apparatus (60) for the wired data transmission.

9. The device according to claim 7 or 8,
**characterized in that**
the data interface (60) is designed having a transmitter and receiver apparatus (60) for the wireless data transmission.

10. The device according to any one of the claims 1 to 9,
**characterized by**
a signaling apparatus (62) for indicating the measured values and for optically and/or acoustically displaying warning and status notifications.

11. The device according to any one of the claims 1 to 10,
**characterized by**
a test apparatus (64) for testing the residual-current triggering.

12. The device according to any one of the claims 1 to 11,
**characterized by**
a power supply (66) for supplying power from the power supply network (4).

13. A device for insulation fault location in an ungrounded power supply network (4), the device having a test device for generating a test current and having an insulation fault location device (2) according to any one of the claims 1 to 12.

14. The device according to claim 13,
**characterized by**
a signaling device for displaying the measured values and for optically and/or acoustically displaying warning and status notifications.

15. The device according to claim 13 or 14,
**characterized by**
a central evaluation device for processing the data of several measuring channels.

16. The device according to claim 14 or 15,
**characterized in that**
a data transmission path is installed between the insulation fault location device (2) according to the invention and the signaling device and/or between the insulation fault location device (2) according to the invention and the evaluation device.

17. The device according to claim 16,
**characterized in that**
the data transmission path is wired and has transmitter and receiver apparatuses (60).

18. The device according to claim 16 or 17,
**characterized in that**
the data transmission path is wireless and has transmitter and receiver apparatuses (60).

## Revendications

1. Dispositif (2) de localisation de défaut d'isolement pour la localisation de défaut d'isolement dans un réseau électrique (4) non mis à la terre ayant des conducteurs (L1, L2) actifs, le dispositif (2) de localisation de défaut d'isolement ayant exactement une chaîne de mesure et au moins un appareil (20) à mesure de courant et un appareil d'évaluation (24), l'appareil (20) à mesure de courant et l'appareil d'évaluation (24) étant configurés comme unité structurelle intégrée en forme d'une pièce additionnelle (2) ou en forme d'une pièce d'adaptateur (2), la pièce additionnelle (2) étant formée comme prise (70) ayant une connexion de prise compatible avec un contact de protection ou la pièce d'adaptateur (2) étant formée comme fiche intermédiaire pour être enfichée sur une connexion de prise compatible avec un contact de protection et l'appareil d'évaluation (24) ayant un microprocesseur (54) ayant une unité de stockage (56) et un ou plusieurs convertisseurs analogiques-numériques (52),
**caractérisé en ce que**
le dispositif (2) de localisation de défaut d'isolement est configuré pour la mesure d'un courant différentiel résiduel dans un système électrique non mis à la terre et mis à la terre, chaque système électrique ayant des conducteurs (L1, L2) actifs, **en ce que** le dispositif (20) à mesure de courant est configuré comme transformateur (28) à courant de mesure, **en ce que** le transformateur (28) à courant de mesure est configuré pour l'enregistrement d'un courant de test et pour la mesure d'un courant différentiel résiduel, et **en ce que** le transformateur (28) à courant de mesure encercle les conducteurs (L1, L2) actifs.

2. Dispositif selon la revendication 1,
**caractérisé en ce que**
la pièce additionnelle (2) est configurée d'avoir des contacts électriques pour la connexion directe des alimentations (4) électriques.

3. Dispositif selon la revendication 1 ou la revendication 2,
**caractérisé en ce**
**qu'**un dispositif (20) à mesure de courant additionnel (20) est configuré comme résistance shunt (26) pour la mesure d'un courant en charge.

4. Dispositif selon l'une quelconque des revendications 1 à 3,
**caractérisé par**
un circuit (22) de couplage de réseau pour la mesure d'une tension de réseau et une tension de masse.

5. Dispositif selon l'une quelconque des revendications 1 à 4,
**caractérisé en ce que**
l'appareil d'évaluation (24) a un chemin de signal ayant un circuit amplificateur et un circuit filtrant subséquent pour la mesure de ce qui suit : un courant différentiel résiduel, un courant de test, un courant en charge, une tension de réseau et une tension de masse.

6. Dispositif selon la revendication 5,
**caractérisé en ce que**
les circuits filtrants (34, 36, 42, 46, 50) sont configurés comme implémentations de software sous forme numérique.

7. Dispositif selon l'une quelconque des revendications 1 à 6,
**caractérisé par**
une interface de données (60) pour le transfert des valeurs mesurées et des signaux d'alarme et des signaux d'état.

8. Dispositif selon la revendication 7,
**caractérisé en ce que**
l'interface de données (60) est configurée avec un appareil émetteur-récepteur (60) pour le transfert de données par fil.

9. Dispositif selon la revendication 7 ou 8,
**caractérisé en ce que**
l'interface de données (60) est configurée avec un appareil émetteur-récepteur (60) pour le transfert de données sans fil.

10. Dispositif selon l'une quelconque des revendications 1 à 9,
**caractérisé par**
un appareil de signalisation (62) pour l'indication des valeurs mesurées et pour l'affichage optique et/ou acoustique de notifications d'alarme et d'état.

11. Dispositif selon l'une quelconque des revendications 1 à 10,
**caractérisé par**
un appareil de test (64) pour le test de déclenchement du courant différentiel résiduel.

12. Dispositif selon l'une quelconque des revendications 1 à 11,
**caractérisé par**
une alimentation électrique (66) pour la propre alimentation électrique du réseau électrique (4).

13. Dispositif pour la localisation de défaut d'isolement dans un réseau électrique (4) non mis à la terre, le dispositif ayant un dispositif de test pour la génération d'un courant de test et ayant un dispositif (2) de défaut de localisation d'isolement selon l'un quelconque des revendications 1 à 12.

14. Dispositif selon la revendication 13,
**caractérisé par**
un dispositif de signalisation pour l'indication de valeurs mesurées et pour l'affichage optique et/ou acoustique des notifications d'alarme et des notifications d'état.

15. Dispositif selon la revendication 13 ou 14,
**caractérisé par**
un dispositif d'évaluation central pour le traitement de données des plusieurs chaînes de mesure.

16. Dispositif selon la revendication 14 ou 15,
**caractérisé en ce**
**qu'**un chemin de transfert de données est installé entre le dispositif (2) de localisation de défaut d'isolement selon l'invention et le dispositif de signalisation et/ou entre le dispositif (2) de localisation de défaut d'isolement selon l'invention et le dispositif d'évaluation.

17. Dispositif selon la revendication 16,
**caractérisé en ce que**
le chemin de transfert de données est conçu d'être par fil et a des appareils émetteur-récepteur (60).

18. Dispositif selon la revendication 16 ou 17,
**caractérisé en ce que**
le chemin de transfert de données est conçu d'être sans fil et a des appareils émetteur-récepteur (60).
